## Europäisches Patentamt

## European Patent Office

## Office européen des brevets

(11) Numéro de publication: **0 028 572**
**B1**

(12) **FASCICULE DE BREVET EUROPEEN**

(45) Date de publication du fascicule du brevet: **20.03.85**

(21) Numéro de dépôt: **80401555.0**

(22) Date de dépôt: **31.10.80**

(51) Int. Cl.⁴: **C 23 C 16/40,** C 03 C 17/245

(54) Procédé et dispositif de dépôt d'un film d'oxydes métalliques.

(30) Priorité: **31.10.79 JP 139800/79**

(43) Date de publication de la demande:
**13.05.81 Bulletin 81/19**

(45) Mention de la délivrance du brevet:
**20.03.85 Bulletin 85/12**

(84) Etats contractants désignés:
**BE DE FR GB IT**

(56) Documents cités:
**FR-A-1 217 676**
**FR-A-2 210 583**
**FR-A-2 241 630**
**FR-A-2 277 047**
**US-A-3 754 529**
**US-A-4 182 783**

(73) Titulaire: **SAINT-GOBAIN VITRAGE**
**Les Miroirs 18, avenue d'Alsace**
**F-92400 Courbevoie (FR)**

(72) Inventeur: **Kawahara, Hideo**
**10 Inano-cho 7-chome**
**Itami-shi Hyogo-ken (JP)**
Inventeur: **Hyodo, Masato**
**11go 18 Danjo-cho 6-chome**
**Nishinomiya-shi Hyogo-ken (JP)**

(74) Mandataire: **Eudes, Marcel et al**
**Saint-Gobain Recherche 39 Quai Lucien Lefranc**
**F-93304 Aubervilliers Cedex (FR)**

Courier Press, Leamington Spa, England.

## Description

La présente invention concerne un procédé de génération de la vapeur des matières premières, dans le cadre de la méthode de dépôt d'un film par vaporisation chimique (abrégé ci-après méthode CVD), autrement dit la méthode au moyen de laquelle on obtient un film de produits de décomposition, en mettant les matières premières sous forme d'une vapeur que l'on dirige sur le support à revêtir, support à base de verre, etc., à la surface duquel elle se décompose sous l'effet de la chaleur.

Depuis longtemps, la méthode CVD est utilisée pour fabriquer à une petite échelle des vitrages conducteurs d'électricité par dépôt d'un film transparent d'oxyde d'étain, d'oxyde d'indium, etc.

Cette méthode revient en pratique à chauffer les matières premières, telles que des composés organiques de métaux, dans un vaporisateur fermé puis à entraîner cette vapeur vers la surface du verre à l'aide d'un gaz porteur.

Ainsi, le document FR—A—1 217 676 décrit l'introduction de matières premières actives en poudre dans une chambre de vaporisation chauffée, dans laquelle on injecte en même temps un gaz inerte, destiné à emporter les vapeurs actives produites, en direction du substrat à revêtir.

Selon cette méthode et en particulier selon la technique décrite dans ce document FR—A—1 217 676, il est difficile d'obtenir l'uniformité thermique entre les zones du vaporisateur proches des parois et les zones centrales, ce qui se traduit par une irrégularité de vaporisation et donc un manque d'homogénéité du mélange de vapeur et de gaz préjudiciable à la qualité du revêtement sur le substrat.

De plus, dans certains cas, étant donné que la quantité de matières premières occupant le volume total du vaporisateur diminue au fur et à mesure que le temps passe, le débit de la vapeur de matières premières dans le gaz porteur varie fortement au cours du temps. C'est pourquoi on s'efforce du régulariser ce débit en réglant le débit du gaz porteur ou la température de l'intérieur du vaporisateur dès le début de la vaporisation. Cette régulation se fait à partir du contrôle des valeurs caractéristiques du film déposé sur le verre. On se rend donc compte qu'il est difficile d'obtenir en continu un film de caractéristiques uniformes et de ce point de vue, la méthode CVD n'est pas pratique. D'autre part, la perte de matières premières, entre le début du chauffage du vaporisateur et la stabilisation du débit de la vapeur engendrée, puis entre l'arrêt de la projection de la vapeur sur la surface du verre et l'arrêt de la formation de la vapeur, n'est pas négligeable.

La présente invention a pour but de fournir un procédé permettant de stabiliser rapidement le débit de la vapeur de matières premières engendrée selon la méthode CVD et maintenir ce débit stable dans le temps.

Selon cette invention, les matières premières en poudre sont fournies de façon continue, dispersées et mises en suspension dans le courant de gaz porteur traversant une toyauterie, puis chauffées et vaporisées dans le gaz porteur dans le tronçon aval de la tuyauterie; le mélange de gaz ainsi créé à partie du gaz porteur et de la vapeur des matières premières est est stabilisé dans une section élargie du tronçon aval de tuyauterie, puis est mis en contact comme auparavant avec la surface du verre chauffé.

Ce procédé supprime les difficultés liées à la variation du débit de la vapeur due à l'abaissement progressif du niveau du liquide dans le vaporisateur. Et, de plus, étant donné que les matières premières en poudre sont dispersées et mises en suspension dans le courant de gaz porteur avant d'être chauffées et vaporisées, leur délai de vaporisation est court et le taux de cette vaporisation partout uniforme. Par conséquent, la vaporisation peut se stabiliser rapidement à partir du début de chauffage et sa régulation s'obtient facilement par le réglage de l'alimentation en matières premières, une fourniture continue d'un débit fixe de vapeur en face du verre résultant d'une alimentation continue en matières premières depuis le commencement du chauffage.

La présente invention, rend la méthode CVD, jusqu'alors peu appropriée à une fabrication à grande échelle, applicable à la fabrication de produits verriers revêtus d'un film d'oxydes métalliques, tels que le verre transparent conducteur d'électricité, le verre réfléchissant des rayons calorifique, etc.

La mise en oeuvre de l'invention est précisée ci-après.

La granulométrie des matières premières en poudre utilisées doit être déterminée en fonction de la vitesse du gaz porteur de façon à ce que les matières premières restent en suspension et uniformément dispersées et ne se déposent pas dans la tuyauterie transporteuse. En général, il est souhaitable que le diamètre des grains soit inférieur à 200 $\mu$m, de préférence, inférieur à 30 $\mu$m.

Les matières premières sont choisies suivant la nature du film que l'on se propose de fabriquer, Par exemple, dans le cas d'un film d'oxyde d'étain, on peut utiliser des composés organiques d'étain tels que $(CH_3)_2SnCl_2$, $(C_4H_9)_2SnCl_2$, $Sn(C_2H_5)_4$, $SnO(C_2H_5)_2$, etc. Dans le cas d'un film d'oxyde d'indium, on peut utiliser des dérivés d'indium du 2,2,6,6-heptane-3,5- diol, l'acétylacétonate d'indium $In(C_5H_7O_2)_3$, etc.

La nature des gaz porteurs utilisés selon la méthode de cette invention est indifférente dans la mesure où ils ne réagissent pas de façon néfaste sur les matières premières. Du point de vue de la facilité de l'emploi et de la sécurité, l'air, la vapeur d'eau ou des gaz inertes sont appropriés.

Pour mélanger et disperser les matières premières en poudre dans le courant de gaz porteur, il est simple et commode d'installer un éjecteur sur la tuyauterie transporteuse du gaz porteur, pour introduire les matières premières sous l'effet de la dépression dans le gaz porteur traversant rapidement cet éjecteur. On peut encore créer le mélange en branchant un tuyau d'alimentation en gaz porteur sur un récipient renfermant les matières premières sous forme d'un lit fluidisé.

En ce qui concerne le chauffage des matières premières dans le courant de gaz porteur, il n'est pas nécessair d'installer une chambre de chauffage spéciale et il suffit de chauffer l'ensemble de la tuyauterie de gaz porteur à l'aide de résistances chauffantes enroulées sur cette tuyauterie en aval du dispositif de chargement des matières premières.

L'invention sera maintenant décrite en détail, en référence aux figures qui représentent:

Fig. 1 une vue de côté de l'équipement utilisé selon l'invention.

Fig. 2 un graphique comparant les variations dans le temps des épaisseurs des films obtenus selon la méthode CVD classique et selon le procédé de cette invention.

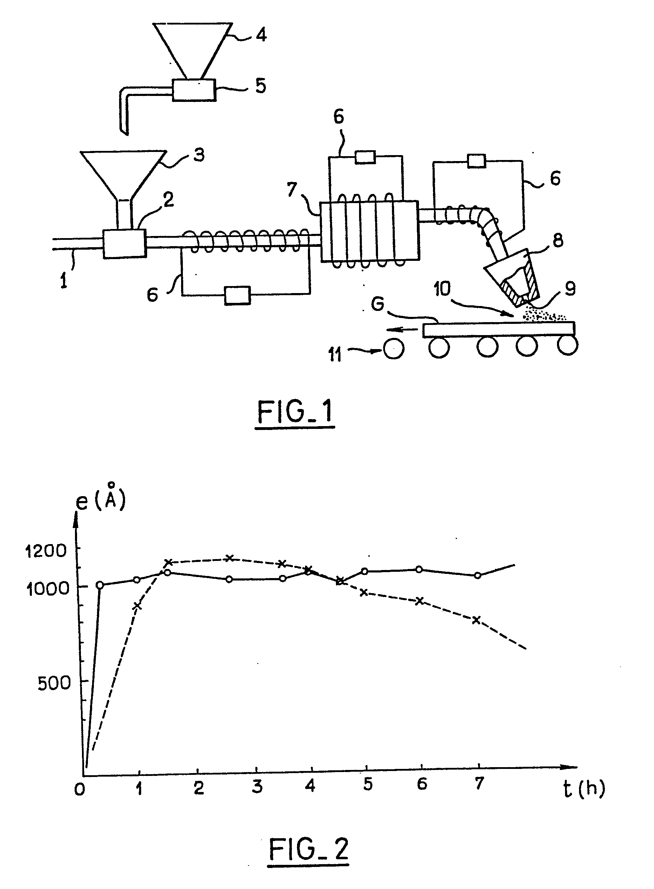

La Fig. 1 représente une tuyauterie 1 traversée de de gauche à droite par le courant de gaz porteur, en l'occurence de l'air comprimé, envoyé depuis un compresseur d'air non représenté.

A mi-chemin de cette tuyauterie 1 est installé l'éjecteur 2 où les matières premières en poudre tombent depuis une trémite intermédiaire 3 surmontée d'une autre trémie 4, de stockage des matières premières. Ces dernières sont fournies continuellement à la trémie intermédiaire 3 par un dispositif d'alimentation à débit constant 5 lié à la trémie de stockage 4. En aval de l'éjecteur 2, la tuyauterie 1 est chauffée à température déterminée à l'aide des réchauffeurs 6 que l'on peut régler à volonté de façon que les matières premières en poudre en suspension dans l'air porteur soient vaporisées pendant qu'elles traversent le tronçon chauffé.

Le mélange du gaz porteur et de la vapeur de matières premières ainsi engendrée entre ensuite dans un réservoir de stabilisation de la concentration en vapeur 7 où de nombreuses chicanes horizontales et verticales forment un labyrinthe à travers lequel la vapeur de matières premières et l'air porteur se mélangent intimement. En outre, la section de passage dans le réservoir 7 est suffisamment importante par rapport à celle de la tuyauterie 1 pour que le pompage du courant d'air dû au fonctionnement du compresseur se trouve absorbé.

A sa sortie du réservoir 7, le mélange formé par la vapeur de matières premières et l'air porteur est amené à un ajutage 8 puis projeté par une buse 9 en forme de fente sur la surface de la feuille de verre G chauffée à une haute température et entraînée dans le sens de la flèche au moyen d'un convoyeur 11.

Dans le réservoir de stabilisation de la concentration en vapeur 7 puis entre celui-ci et l'ajutage 8, la tuyauterie est encore chauffée à l'aide de réchauffeurs 6', 6'' pour éviter la condensation de la vapeur de matières premières et pour maintenir une température déterminée.

Exemple

Comme matière première, on a utilisé une poudre de chlorure de di-méthyl étain ayant un diamètre de grains compris entre 5 et 25 $\mu$m, avec une valeur moyenne de 10 $\mu$m. En utilisant l'équipement indiqué à la Fig. 1, on l'a introduit à raison de 10 g/mn dans un courant d'air porteur ayant une vitesse de 7,8 m/mn, la tuyauterie en aval du dispositif de chargement étant chauffée à 120°C de façon à projeter continuellement la vapeur de la matière première à partir de l'ajutage 8. On a envoyé des plaques de verre chauffées à 550°C à intervalles irréguliers au moyen du convoyeur 11 et mesuré l'épaisseur du film d'oxyde d'étain déposé sur chaque plaque de verre. Les résultats en sont indiqués en trait plein sur le graphique de la Fig. 2, où le temps passé en heures depuis le commencement du chauffage est représenté en abscisses et l'épaisseur du film, exprimée en Å, en ordonnées.

A titre comparatif, on a chauffé 1 kg de la matière première précitée à 120°C dans un vaporisateur selon la méthode CVD classique, dirigé la vapeur obtenue vers l'ajutage par un courant d'air porteur dans les mèmes conditions que ci-dessus puis projeté celle-ci sur des plaques de verre chauffées à 550°C et à nouveau mesuré la variation de l'épaisseur du film au cours du temps.

Les résultats sont indiqués en trait pointillé sur la Fig. 2, le graphique montre qu'en comparaison avec la méthode CVD classique, l'invention permet de réduire fortement le temps de stabilisation de l'épaisseur du film et de minimiser la variation temporelle de l'épaisseur du film donc d'obtenir un film ayant une épaisseur uniforme.

**Revendications**

1. Procédé de dépôt d'un film d'oxydes métalliques sur un support, consistant à mettre les matières premières sous forme de vapeur qu'un courant de gaz porteur dirige vers ce support chauffé de façon à provoquer leur décomposition thermique, charactérisé en ce qu'on introduit, disperse et met en suspension de façon continue les matières premières en poudre dans le courant de gaz porteur traversant une tuyauterie, puis on vaporise lesdites matières premières dans le gaz porteur en chauffant l'ensemble du tronçon aval de ladite tuyauterie avant de mélanger intimement la vapeur de matières premières et le gaz porteur, dans une section élargie dudit tronçon.

2. Procédé selon la revendication 1, caractérisé en ce que le diamètre des grains de matières premières en poudre est inférieur à 200 $\mu$m.

3. Dispositif pour le dépôt d'un film d'oxyde selon l'une des revendications précédentes comprenant une tuyauterie (1) aboutissant à une buse de projection (9) d'un gaz porteur chargé des vapeurs de matières premières, caractérisé en ce qu'il comprend successivement le long de la tuyauterie: un éjecteur d'aspiration (2) de ces matières en poudre, des organes de chauffage (6) disposés sur l'ensemble du tronçon aval de la tuyauterie (1) dans lequel a lieu la vaporisation, et en réservoir de mélange et de stabilisation (7) du débit gazeux.

## Patentansprüche

1. Verfahren zur Ablagerung einer dünnen Schicht aus Metalloxiden auf eine Unterlage, bei welchem die Rohmaterialien verdampft und mittels eines Trägergasstroms gegen die erhitzte Unterlage geführt werden, derart, daß eine thermische Zersetzung des Rohmaterials stattfindet, dadurch gekennzeichnet, daß in kontinuierlicher Weise der Rohmaterialien in Pulverform in den eine Leitung durchströmenden Trägergasstrom eingeführt, dispergiert und in Suspension gebracht werden, und daß dann die Rohmaterialien im Trägergasstrom durch Erwärmung des gesamten stromabwärtigen Teils der Leitung verdampf werden, bevor die verdampften Rohmaterialien und das Trägergas in einem vergrößerten Abschnitt der Leitung innig vermischt werden.

2. Verfahren nach Anspruch 1, dadurch gekennzeichnet, daß der Korndurchmesser der pulverförmigen Rohmaterialien geringer als 200 $\mu$m ist.

3. Vorrichtung zur Ablagerung einer dünnen Oxidschicht gemäß Anspruch 1 oder 2, mit einer Leitung (1), welche in eine Strahldüse für ein Trägergas mündet, welches mit den verdampften Rohmaterialien beladen ist, dadurch gekennzeichnet, daß die Vorrichtung hintereinander über die Länge der Leitung eine Saugstrahleinrichtung (2) für die pulverförmigen Materialien, Heizeinrichtungen (6), welche über den gesamten stromabwärtigen Teil der Leitung (1) angeordnet sind, in welchem die Verdampfung stattfindet, und einen Mischungs- und Stabilisationsbehälter (7) für die gasartige Menge aufweist.

## Claims

1. A method of depositing a film of metallic oxides on a support, consisting of providing the starting materials in the form of vapour which a stream of carrier gas directs towards the support which is heated so as to cause their thermal decomposition, characterised in that the starting materials in powder form are introduced, dispersed and put in suspension continuously in the stream of carrier gas passing through piping, then said starting materials are vapourised in the carrier gas by heating a downstream portion of said piping before intimate mixing of the vapour of the starting materials and the carrier gas in an enlarged section of said portion.

2. A method according to Claim 1, characterised in that the diameter of the grains of the powder starting materials is less than 200 $\mu$m.

3. Device for depositing an oxide film according to any one of the preceding claims comprising piping (1) leading to a projection nozzle (9) for a carrier gas containing vapour of the starting materials, characterised in that it comprises successively along the piping; an aspiration ejector (2) for the powder materials, heating members (6) arranged on the downstream portion of the piping (1) in which vapourisation takes place, and a reservoir for mixing and stabilisation (7) of the gaseous flow.

## FIG_1

## FIG_2